# EUROPEAN PATENT APPLICATION

(11) **EP 4 583 654 A1**
(43) Date of publication of application: **09.07.2025**
(21) Application number: 23875124.2
(22) Date of filing: 21.09.2023
(51) Int. Cl.: H05K 9/00, H04M 1/02, H01Q 1/24

(54) **ROLLABLE ELECTRONIC DEVICE COMPRISING SHIELDING MEMBER**

(30) Priority: 05.10.2022 KR 20220127211; 04.11.2022 KR 20220145845
(71) Applicant: Samsung Electronics Co., Ltd., Suwon-si, Gyeonggi-do 16677 (KR)
(72) Inventor: KWAK, Myunghoon, Suwon-si Gyeonggi-do 16677 (KR); YOU, Jaehyoung, Suwon-si Gyeonggi-do 16677 (KR); KIM, Junhyuk, Suwon-si Gyeonggi-do 16677 (KR); JEONG, Hoyoung, Suwon-si Gyeonggi-do 16677 (KR)
(74) Representative: Gulde & Partner
(86) International application number: PCT/KR2023/014374
(87) International publication number: WO 2024/076057

(57) **Abstract**

An electronic device may be provided. The electronic device may comprise: a housing which includes a first housing and a second housing configured to be moved relative to the first housing; a display which is configured to be unrolled on the basis of sliding of the second housing; an electronic component which is disposed in the housing and configured to sense a magnetic field; a magnet which is disposed in the housing, includes a first end and a second end opposite to the first end, and has a circular arc shape; and a shielding member, at least a part of which is disposed between the first end and the second end and at least a part of which is positioned on an extension line between the center point of the magnet and the electronic component.

## Description

### [Technical Field]

Various embodiments of the disclosure relate to a rollable electronic device including a shielding member.

### [Background Art]

Due to advancement in information and communication technology and semiconductor technology, various functions are being integrated into a single portable electronic device. For example, an electronic device may implement not only communication functions, but also entertainment functions such as gaming, multimedia functions such as music/video playback, communication and security functions for mobile banking and the like, and functions for schedule management and an electronic wallet function. These electronic devices are being miniaturized to be conveniently carried by users.

As mobile communication services extend into the multimedia service domain, it is necessary to increase the display sizes of electronic devices in order to allow users to fully utilize multimedia services, in addition to voice calls and short message services. However, the display sizes of electronic devices may be in a trade-off relationship with the miniaturization of electronic devices.

### [Detailed Description of the Invention]

### [Technical Solution]

According to an embodiment of the disclosure, an electronic device may include a housing including a first housing and a second housing configured to move relative to the first housing, a display configured to be unrolled based on the sliding of the second housing, an electronic component disposed within the housing and configured to detect a magnetic field, a magnet disposed within the housing, including a first end and a second end facing the first end, and having an arc shape, and a shielding member having at least a portion positioned between the first end and the second end, and at least a portion positioned on an extension line between the center point of the magnet and the electronic component.

According to an embodiment of the disclosure, an electronic device may include a housing including a first housing and a second housing configured to move relative to the first housing, a display configured to be unrolled based on the sliding movement of the second housing, a position determination magnet disposed within in the housing, a magnetic field detection sensor configured to slide relative to the position determination magnet and including a hall sensor configured to detect a magnetic field generated from the position determination magnet, a magnet disposed within the housing and including a first end and a second end facing the first end, and a shielding member at least partially positioned between the first end and the second end, and positioned on an extension line between the center point of the magnet and the hall sensor.

### [Brief Description of Drawings]

FIG. 1 is a block diagram of an electronic device according to an embodiment of the disclosure in a network environment.
FIG. 2 is a view illustrating the state in which a second display area of a display according to an embodiment of the disclosure is accommodated in a housing.
FIG. 3 is a view illustrating the state in which the second display area of the display according to an embodiment of the disclosure is exposed to the exterior of the housing.
FIG. 4 is an exploded perspective view of an electronic device according to an embodiment of the disclosure.
FIG. 5A is a cross-sectional view of an embodiment of the disclosure, taken along line A-A' in FIG. 2. FIG. 5B is a cross-sectional view of an embodiment of the disclosure, taken along line B-B' in FIG. 3.
FIG. 6 is a perspective view of a driving structure according to an embodiment of the disclosure.
FIG. 7 is a rear view of an electronic device according to an embodiment of the disclosure.
FIG. 8 is an exploded perspective view of an accessory and an electronic device including a magnet according to an embodiment of the disclosure.
FIG. 9 is a rear perspective view of an electronic device according to an embodiment of the disclosure.
FIG. 10 is a front view of an electronic device including a magnet, a shielding member, and a magnetic field detection sensor according to an embodiment of the disclosure.
FIG. 11 is a view illustrating a positional relationship of a magnet according to an embodiment of the disclosure.
FIGS. 12A and 12B are views illustrating a positional relationship between a magnet and a hall sensor according to an embodiment of the present disclosure.
FIGS. 13A and 13B are views illustrating a structure for designing the shape of a magnet according to an embodiment of the disclosure.
FIG. 14A is a view illustrating the structure of an electronic device facing an external accessory.
FIG. 14B is a cross-sectional view taken along line C-C' of FIG. 15.
FIG. 15 is a front view of an electronic device including a magnet and a shielding member with an external magnet attached thereto according to an embodiment of the disclosure.
FIG. 16 is a view of a shielding member according to an embodiment of the disclosure.
FIGS. 17A and 17B are views illustrating a positional relationship between the shielding member and the hall sensor according to an embodiment of the disclosure.

### [Mode for Carrying out the Invention]

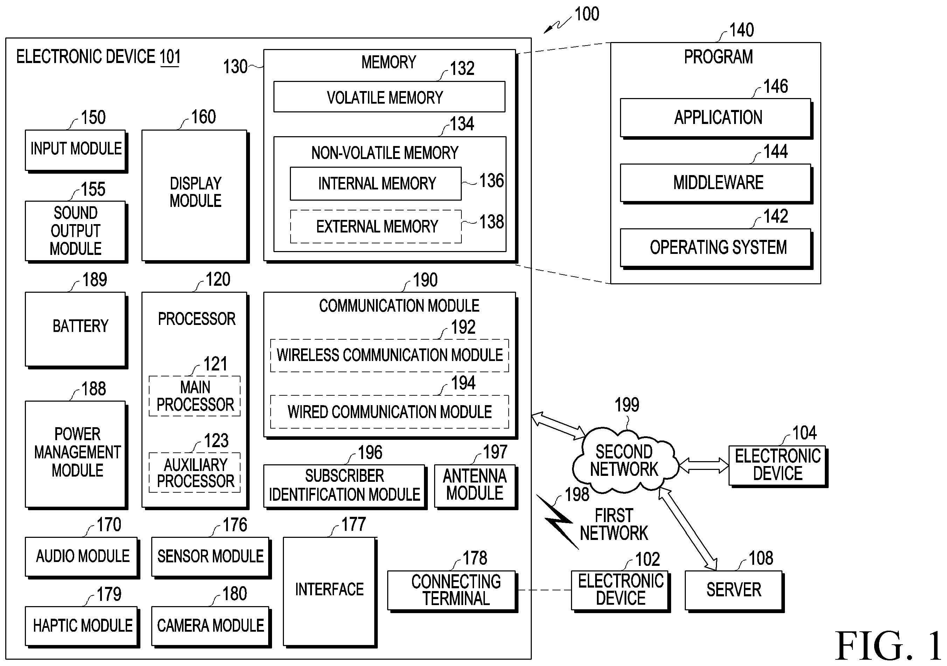

FIG. 1 is a block diagram illustrating an electronic device in a network environment according to an embodiment of the disclosure.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

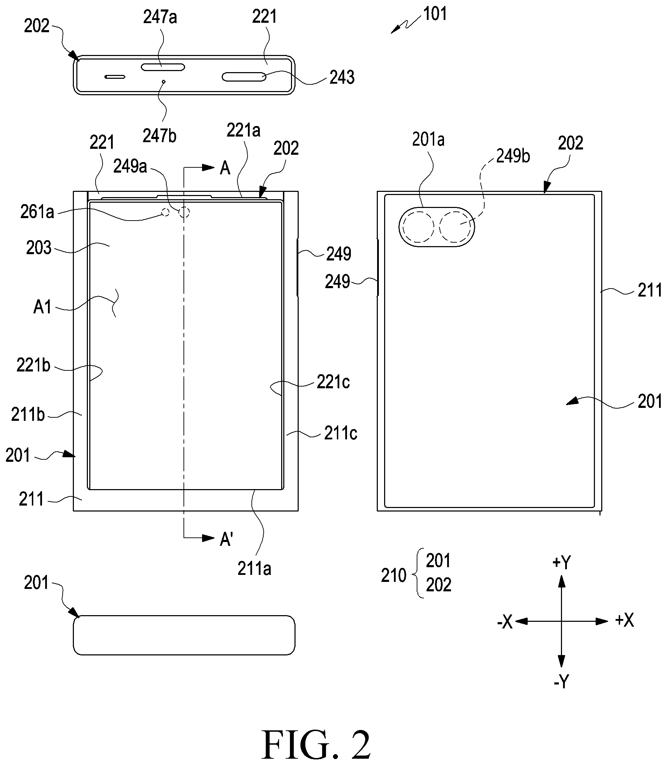

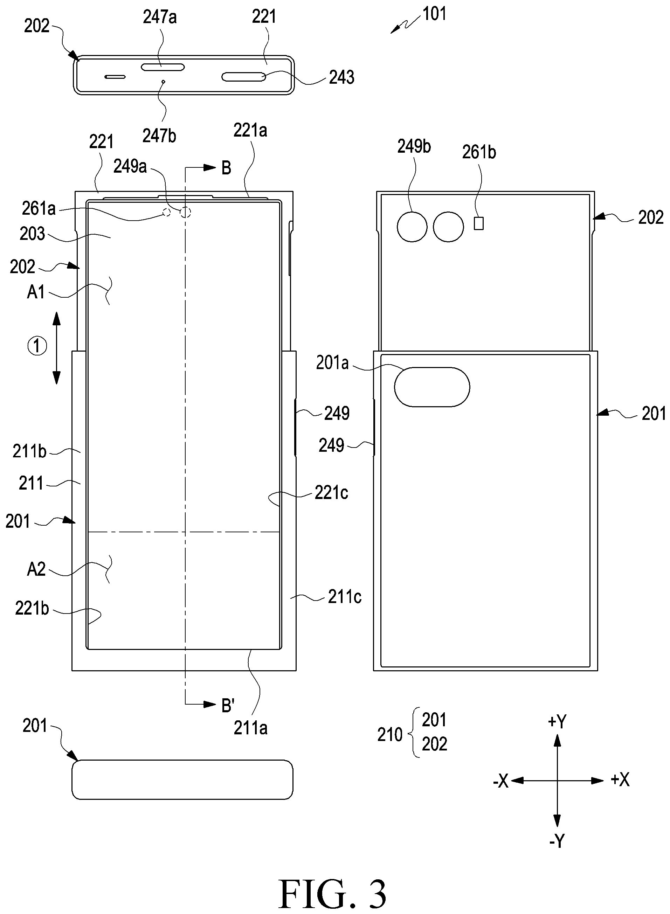

FIG. 2 is a view illustrating the state in which a second display area of a display according to an embodiment of the disclosure is accommodated in a housing. FIG. 3 is a view illustrating the state in which the second display area of the display according to an embodiment of the disclosure is exposed to the exterior of the housing.

FIGS. 2 and 3 illustrate a structure in which a display 203 (e.g., a flexible display or rollable display) is expanded in the longitudinal direction (e.g., the +Y direction) when viewed from the front of the electronic device 101. However, the expansion direction of the display 203 is not limited to one direction (e.g., the +Y direction). For example, a design change may be made such that the display 203 may be expanded upward (e.g., in the +Y direction), rightward (e.g., in the +X direction), leftward (e.g., in the -X direction), and/or downward (e.g., in the -Y direction).

The state illustrated in FIG. 2 may be referred to as a slid-in state of the electronic device 101 or a state in which the second display area A2 of the display 203 is closed.

The state illustrated in FIG. 3 may be referred to as a slid-out state of the electronic device 101 or a state in which the second display area A2 of the display 203 is opened.

Referring to FIGS. 2 and 3, the electronic device 101 may include a housing 210. The housing 210 may include a first housing 201 and a second housing 202 disposed to be movable relative to the first housing 201. In an embodiment, the electronic device 101 may be interpreted as having a structure in which the first housing 201 is disposed to be slidable relative to the second housing 202. According to an embodiment, the second housing 202 may be disposed to be able to reciprocate by a predetermined distance in the illustrated direction (e.g., the direction indicated by arrow ①) relative to the first housing 201.

According to an embodiment, the second housing 202 may be referred to as a slide portion or a slide housing and may be movable relative to the first housing 201. According to an embodiment, the second housing 202 may accommodate various electrical and electronic components such as a circuit board and a battery.

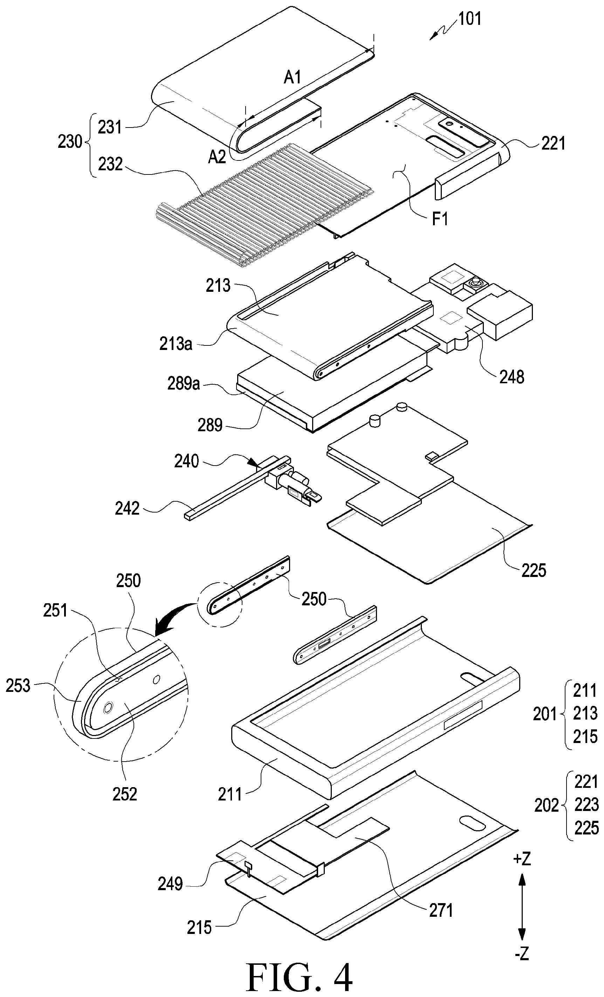

According to an embodiment, the first housing 201 may accommodate a motor, a speaker, a SIM socket, and/or a sub-circuit board (e.g., the second circuit board 249 in FIG. 4) electrically connected to the main circuit board. The second housing 202 may accommodate a main circuit board (e.g., the first circuit board 248 in FIG. 4) on which electrical components such as an application processor (AP) and a communication processor (CP) are mounted.

According to an embodiment, the first housing 201 may include a first cover member 211. The first cover member 211 may include a (1-1)^{th} side wall 211a, a (1-2)^{th} side wall 211b extending from the (1-1)^{th} side wall 211a, and a (1-3)^{th} side wall 211a extending from the (1-1)^{th} side wall 211c substantially parallel to the (1-2)^{th} side wall 211b. According to an embodiment, the (1-2)^{th} side wall 211b and the (1-3)^{th} side wall 211c may be substantially perpendicular to the (1-1)^{th} side wall 211a. According to an embodiment, the first cover member 211 may be referred to as a main case or a cover member.

According to an embodiment, the (1-1)^{th} side wall 211a, the (1-2)^{th} side wall 211b, and the (1-3)^{th} side wall 211c of the first cover member 211 may have a shape that is open on one side (e.g., the front surface) to accommodate (or surround) at least a portion of the second housing 202. For example, at least a portion of the second housing 202 may be surrounded by the first housing 201 and may be slid in a direction parallel to a first surface (e.g., the first surface F1 in FIG. 4) (e.g., the direction indicated by arrow ①) while being guided by the first housing 201. According to an embodiment, the (1-1)^{th} side wall 211a, the (1-2)^{th} side wall 211b, and/or the (1-3)^{th} side wall 211c of the first cover member 211 may be integrally configured. According to an embodiment, the (1-1)^{th} side wall 211a, the (1-2)^{th} side wall 211b, and/or the (1-3)^{th} side wall 211c of the first cover member 211 may be provided as separate structures and coupled or assembled to each other.

According to an embodiment, the first cover member 211 may be configured to surround at least a portion of a display 203. For example, the display 203 may be provided to be at least partially surrounded by the (1-1)^{th} side wall 211a, the (1-2)^{th} side wall 211b, and/or the (1-3)^{th} side wall 211c of the first cover member 211.

According to an embodiment, the second housing 202 may include a second cover member 221 (e.g., a slide plate). The second cover member 221 may have a plate shape and include a first surface (e.g., the first surface F1 in FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a (2-1)^{th} side wall 221a, a (2-2)^{th} side wall 221b extending from the (2-1)^{th} side wall 221a, and a (2-3)^{th} side wall 221c extending from the (2-1)^{th} side wall 221a substantially parallel to the (2-2)^{th} side wall 221b. According to an embodiment, the (2-2)^{th} side wall 221b and the (2-3)^{th} side wall 221c may be substantially perpendicular to the (2-1)^{th} side wall 221a. According to an embodiment, the second cover member 221 may be referred to as an auxiliary cover member.

According to an embodiment, as the second housing 202 moves in the first direction (e.g., direction ①) parallel to the (2-2)^{th} side wall 211b or the (2-3)^{th} side wall 211c, the electronic device 101 may be in the slid-in state and the slid-out state. In the slid-in state of the electronic device 101, the second housing 202 is positioned at a first distance from the (1-1)^{th} side wall 211a of the first housing 201, and in the slid-out state of the electronic device 101, the second housing 202 may be moved to be positioned at a second distance greater than the first distance from the (1-1)^{th} side wall 211a of the first housing 201. In an embodiment, in the slid-in state of the electronic device 101, the first housing 201 may be configured to partially surround the (2-1)^{th} side wall 221a.

According to an embodiment, the electronic device 101 may be in an intermediate state between the slid-in state of FIG. 2 (e.g., the fully opened state) and the slid-out state of FIG. 3 (e.g., the fully closed state). The distance between the (1-1)^{th} side wall 211a and the (2-1)^{th} side wall 221a in the intermediate state of the electronic device 101 may be smaller than the distance between the (1-1)^{th} side wall 211a and the (2-1)^{th} side wall 211a of the electronic device 101 in the fully opened state and may be greater than the distance between the (1-1)^{th} side wall 211a and the (2-1)^{th} side wall 221a of the electronic device 101 in the fully closed state. According to an embodiment, as at least a portion of the display 203 slides in the intermediate state of the electronic device 101, the area of the display exposed to the outside may be variable. For example, in the intermediate state of the electronic device 101, the ratio of the width (the length in the X direction) and the height (the length in the Y direction) of the display 203 and/or the distance between the (1-1)^{th} side wall 211a and the (2-1)^{th} side wall 221a may be changed based on the slide movement of the electronic device 101.

According to an embodiment, the electronic device 101 may include a display 203, key input devices 245, a connector hole 243, audio modules 247a and 247b, or camera modules 249a and 249b. According to an embodiment, the electronic device 101 may further include an indicator (e.g., an LED device) or various sensor modules.

According to an embodiment, the display 203 may include a first display area A1 and a second display area A2 configured to be exposed to the exterior of the electronic device 101 based on the slide movement of the second housing 202. According to an embodiment, the first display area A1 may be disposed on the second housing 202. For example, the first display area A1 may be disposed on the second cover member 221 of the second housing 202. According to an embodiment, the second display area A2 extends from the first display area A1, and as the second housing 202 slides relative to the first housing 201, the second display area A2 may be accommodated inside the first housing 201 or visually exposed to the exterior of the electronic device 101. According to an embodiment, as the electronic device 101 is changed from the slid-out state to the slid-in state, the display 203 may be expanded in the downward direction of the electronic device 101 (e.g., the -Y direction). For example, when the electronic device 101 is in the slid-out state, the second display area A2 may be visually exposed below the display 203 (e.g., in the -Y direction). According to an embodiment, as the electronic device 101 is changed from the slid-out state to the slid-in state, the display 203 may be expanded in the upward direction of the electronic device 101 (e.g., in the +Y direction). For example, when the electronic device 101 is in the slid-out state, the second display area A2 may be visually exposed above the display 203 (e.g., in the +Y direction).

According to an embodiment, the second display area A2 may move substantially while being guided by an area of the first housing 201 (e.g., the curved surface e in FIG. 4), and may be accommodated in a space positioned inside the first housing 201 or exposed to the exterior of the electronic device 101. According to an embodiment, the second display area A2 may be moved based on the sliding of the second housing 202 in the first direction (e.g., the direction indicated by arrow ①). For example, while the second housing 202 slides, a portion of the second display area A2 may be deformed into a curved shape at a position corresponding to the curved surface 213a of the first housing 201.

According to an embodiment, when viewed from above the second cover member 221 (e.g., the front cover), when the electronic device 101 is changed from the slid-in state to the slid-out state (for example, when the second housing 202 slides to be expanded with respect to the first housing 201), the second display area A2 may form a substantially flat surface together with the first display area A1 while being gradually exposed to the exterior of the first housing 201. According to an embodiment, the display 203 may be coupled to or arranged adjacent to a touchsensing circuit, a pressure sensor that is capable of measuring touch intensity (pressure), and/or a digitizer that detects a magnetic field-type stylus pen. According to an embodiment, regardless whether the electronic device 101 is in the slid-in or slid-out state, a portion of the exposed second display area A2 may be positioned on a portion of the first housing (e.g., the curved surface 213a in FIG. 4), and a portion of the second display area A2 may maintain the curved shape at a position corresponding to the curved surface 213a.

According to an embodiment, the key input devices 245 may be positioned in one area of the housing 210 (e.g., the first housing 201 and/or the second housing 202). Depending on the external appearance and use state, the electronic device 101 may be designed such that the illustrated key input devices 245 are omitted or one or more additional key input devices are included. According to an embodiment, the electronic device 101 may include key input devices (not illustrated), such as a home key button or touch pads arranged around the home key button. According to an embodiment, at least some of the key input devices 245 may be disposed on the (1-1)^{th} side wall 211a, the (1-2)^{th} side wall 211b, and/or the (1-3)^{th} side wall 211c of the first housing 201. According to an embodiment, at least some of the key input devices 245 may be disposed on the (2-1)^{th} side wall 221a, the (2-2)^{th} side wall 221b, and/or the (2-3)^{th} side wall 221c of the second housing 202.

According to an embodiment, the connector hole 243 may be omitted in some embodiments and may accommodate a connector (e.g., a USB connector) for transmitting/receiving power and/or data to/from an external electronic device. According to an embodiment (not illustrated), the electronic device 101 may include a plurality of connector holes 243, and some of the connector holes 243 may function as connector holes for transmitting/receiving audio signals to/from an external electronic device. In the illustrated embodiment, the connector hole 243 is positioned in the second housing 202, but is not limited to thereto. The connector hole 243 or a connector hole (not illustrated) may be positioned in the first housing 201.

According to an embodiment, the audio modules 247a and 247b may include one or more speaker holes 247a or one or more microphone holes 247b. One of the speaker holes 247a may be provided as a receiver hole for a voice call, and another one may be provided as an external speaker hole. The electronic device 101 may include a microphone configured to acquire sound, and the microphone may acquire sound outside the electronic device 101 through the microphone holes 247b. According to an embodiment, the electronic device 101 may include a plurality of microphones in order to detect the direction of sound. According to an embodiment, the electronic device 101 may include an audio module in which the speaker holes 247a and the microphone holes 247b are implemented as a single hole, or a speaker in which the speaker holes 247a are excluded (e.g., a piezo speaker). According to an embodiment, the speaker hole 247a and the microphone hole 247b may be positioned in the first housing 201 and/or the second housing 202.

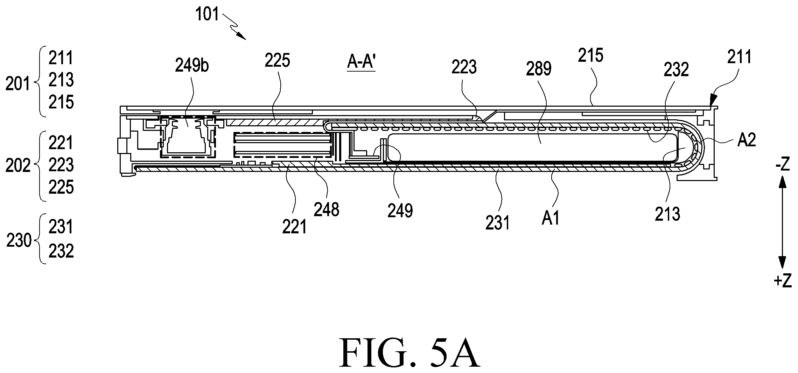

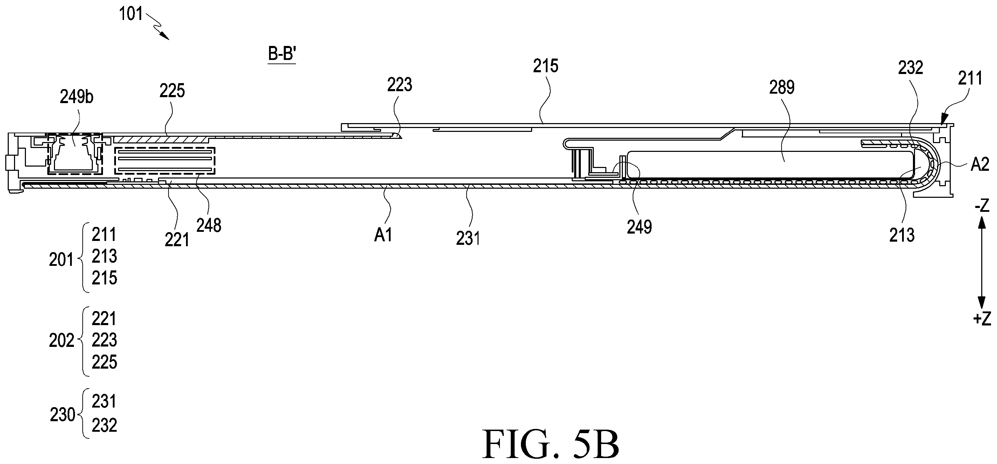

According to an embodiment, the camera modules 249a and 249b may include a first camera module 249a (e.g., a front camera) and a second camera module 249b (e.g., a rear camera) (e.g., the second camera module 249b in FIGS. 5A and 5B). According to an embodiment, the electronic device 101 may include at least one of a wide-angle camera, a telephoto camera, or a close-up camera. In some embodiments, the electronic device 101 may include an infrared projector and/or an infrared receiver to measure the distance to a subject. The camera modules 249a and 249b may include one or more lenses, an image sensor, and/or an image signal processor. The first camera module 249a may be arranged to be oriented in the same direction as the display 203. For example, the first camera module 249a may be arranged around the first display area A1 or in an area overlapping the display 203, and may capture a subject through the display 203 when arranged in the area overlapping the display 203. According to an embodiment, the first camera module 249a may include an under-display camera (UDC) which may be hidden without being visually exposed to a screen display area (e.g., the first display area A1). According to an embodiment, the second camera module 249b may capture a subject in a direction opposite to the first display area A1. According to an embodiment, the first camera module 249a and/or the second camera module 249b may be disposed on the second housing 202. According to an embodiment, a plurality of second camera module 249b may be provided to provide various arrangements. For example, the plurality of second camera modules 249b may be arranged along the width direction (the X-axis direction), which is a direction substantially perpendicular to the slide movement direction (e.g., the Y-axis direction) of the electronic device 101. As another example, the plurality of second camera modules 249b may be arranged along the slide movement direction (e.g., the Y-axis direction) of the electronic device 101. As another example, the plurality of second camera modules 249b may be arranged along N * M rows and columns like a matrix.

According to an embodiment, when the electronic device 101 is in the slid-in state, the second camera module 249b may not be visually exposed to the outside of the electronic device 101, and when the electronic device 101 is in the slid-out state, the second camera module 249b may capture a scene outside the electronic device 101. According to an embodiment, the second camera module 249b may capture a scene outside the electronic device 101 when the electronic device 101 is in the slid-in state and the slid-out state. For example, at least a portion of the housing 210 (e.g., the first rear surface plate 215 and/or the second rear surface plate 225 in FIG. 4) may be substantially transparent, and the second camera module 249b may capture a scene outside the electronic device 101 through the first rear surface plate 215 and/or the second rear surface plate 225.

According to an embodiment, an indicator (not illustrated) of the electronic device 101 may be disposed on the first housing 201 or the second housing 202, and may include a lightemitting diode to provide state information of the electronic device 101 as a visual signal. A sensor module (not illustrated) of the electronic device 101 may generate an electrical signal or a data value corresponding to an internal operating status of the electronic device 101 or an external environmental status. The sensor module may include, for example, a proximity sensor, a fingerprint sensor, or a biometric sensor (e.g., an iris/face recognition sensor or an HRM sensor). In another embodiment, the sensor modules may further include at least one of, for example, a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor. According to an embodiment, the sensor modules may be disposed in the first housing 201 and the second housing 202. For example, at least some of the sensor modules may be positioned in the first housing 201, while some others may be positioned in the second housing 202.

FIG. 4 is an exploded perspective view of an electronic device according to an embodiment of the disclosure. For example, FIG. 4A is a rear exploded perspective view of an electronic device 101 according to an embodiment.

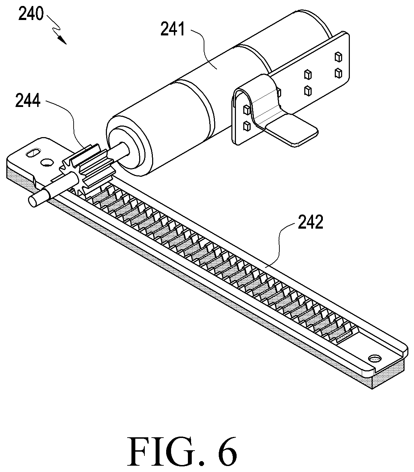

FIG. 5A is a cross-sectional view of an embodiment of the disclosure, taken along line A-A' in FIG. 2. FIG. 5B is a cross-sectional view of an embodiment of the disclosure, taken along line B-B' in FIG. 3. FIG. 6 is a perspective view of a driving structure according to an embodiment of the disclosure.

Referring to FIG. 4, FIG. 5A, FIG. 5B, and/or FIG. 6, the electronic device 101 may include a first housing 201, a second housing 202, a display assembly 230, and a driving structure 240. The components of the first housing 201, the second housing 202, and the display assembly 230 of FIG. 4, FIG. 5A and/or FIG. 5B may be wholly or partially the same as those of the first housing 201, the second housing 202, and the display 203 of FIG. 2 and/or FIG. 3. The embodiment illustrated in FIG. 2 and/or FIG. 3 may be partially combined with the embodiments illustrated in FIG. 4, FIG. 5A, FIG. 5B, and/or FIG. 6. According to an embodiment, the first housing 201 may include a first cover member 211 (e.g., the first cover member 211 in FIGS. 2 and 3), a frame 213, and a first rear surface plate 215.

According to an embodiment, the first cover member 211 may accommodate at least a portion of the frame 213 and a component (e.g., the battery 289) positioned on the frame 213. According to an embodiment, the first cover member 211 may be configured to surround at least a portion of a second housing 202. According to an embodiment, the first cover member 211 may protect components (e.g., the second circuit board 249 and the frame 213) positioned in the first housing 201 from external impact. According to an embodiment, the second circuit board 249, which accommodates electronic components, may be connected to the first cover member 211.

According to an embodiment, the frame 213 may be connected to the first cover member 211. For example, the frame 213 may be connected to the first cover member 211, and the second housing 202 may be moved relative to the first cover member 211 and/or the frame 213. According to an embodiment, the frame 213 may accommodate the battery 289. For example, the frame 213 may include a groove to accommodate the battery 289. The frame 213 may be connected to a battery cover 289a and may surround at least a portion of the battery 289 together with the battery cover 289a. According to an embodiment, the frame 213 may include a curved portion 213a facing the display assembly 230.

According to an embodiment, the first rear surface plate 215 may substantially define at least a portion of the exterior of the first housing 201 or the electronic device 101. For example, the first rear surface plate 215 may be coupled to the outer surface of the first cover member 211. According to an embodiment, the first rear surface plate 215 may provide a decorative effect on the exterior of the electronic device 101. The first rear surface plate 215 may be made of at least one of metal, glass, synthetic resin, or ceramic.

According to an embodiment, the second housing 202 may include a second cover member 221 (e.g., the second cover member 221 in FIGS. 2 and 3), a rear cover 223, and a second rear surface plate 225.

According to an embodiment, the second cover member 221 may be connected to the first housing 201 via a guide rail 250, and may linearly reciprocate in in one direction (e.g., the direction indicated by arrow ① in FIG. 3) while being guided by the guide rail 250.

According to an embodiment, the second cover member 221 may be configured to support at least a portion of the display 203. For example, the second cover member 221 may include a first surface F1, and the first display area A1 of the display 203 may be substantially positioned on the first surface F1 and maintained in a flat plate shape. According to an embodiment, the second cover member 221 may be made of a metal material and/or a non-metal (e.g., polymer) material. According to an embodiment, the first circuit board 248, which accommodates electronic components (e.g., the processor 120 and/or the memory 130 in FIG. 1), may be connected to the second cover member 221. According to an embodiment, the second cover member 221 may protect components (e.g., the first circuit board 248 and the rear cover 223) positioned in the second housing 202 from external impact.

According to an embodiment, the rear cover 223 may protect components (e.g., the first circuit board 248) positioned on the second cover member 221. For example, the rear cover 223 may be connected to the second cover member 221 and surround at least a portion of the first circuit board 248. According to an embodiment, the rear cover 223 may include an antenna pattern for communication with an external electronic device. For example, the rear cover 223 may include a laser direct structuring (LDS) antenna.

According to an embodiment, the second rear surface plate 225 may substantially define at least a portion of the exterior of the second housing 202 or the electronic device 101. For example, the second rear surface plate 225 may be coupled to the outer surface of the second cover member 221. According to an embodiment, the second rear surface plate 225 may provide a decorative effect on the exterior of the electronic device 101. The second rear surface plate 225 may be made of at least one of metal, glass, synthetic resin, or ceramic.

According to an embodiment, the display assembly 230 may include a display 231 (e.g., the display 203 in FIGS. 2 and/or 3) and a multi-bar structure 232 supporting the display 203. According to an embodiment, the display 231 may be referred to as a flexible display, a foldable display, and/or a rollable display. According to an embodiment, the first display area A1 of the display 231 may be supported by a rigid body, and the second display area A2 may be supported by a bendable structure. For example, the first display area A1 may be supported by the first surface F1 of the second cover member 221 or a plate (not illustrated). The second display area A2 may be supported by the multi-bar structure 232.

According to an embodiment, the multi-bar structure 232 may be connected or attached to at least a portion of the display 231 (e.g., the second display area A2). According to an embodiment, as the second housing 202 slides, the multi-bar structure 232 may move relative to the first housing 201. When the electronic device 101 is in the slid-in state (e.g., FIG. 2), the multi-bar structure 232 may be mostly accommodated inside the first housing 201, and may be positioned between the first cover member 211 and the second cover member 221. According to an embodiment, at least a portion of the multi-bar structure 232 may move to correspond to the curved surface 213a positioned at an edge of the frame 213. According to an embodiment, the multi-bar structure 232 may be referred to as a display support member or support structure, and may be in the form of an elastic plate.

According to an embodiment, the driving structure 240 may relatively move the second housing 202 relative to the first housing 201. For example, the driving structure 240 may include a motor 241 configured to generate a driving force for sliding the second housing 202 relative to the first housing 201. The driving structure 240 may include a gear 244 (e.g., a pinion) connected to the motor 241 and a rack 242 configured to be engaged with the gear.

According to an embodiment, the housing in which the rack 242 is positioned and the housing in which the motor 241 is positioned may be different. According to an embodiment, the motor 241 may be connected to the second housing 202, and the rack 242 may be connected to the first housing 201. According to an embodiment, the motor 241 may be connected to the first housing 201, and the rack 242 may be connected to the second housing 202 (e.g., the second cover member 221). For example, the motor 241 may be mounted on the frame 213.

According to an embodiment, the motor 241 may be controlled by a processor (e.g., the processor 120 in FIG. 1). For example, the processor 120 may include a motor driver driving circuit and deliver a pulse width modulation (PWM) signal to the motor 241 to control the speed of the motor 241 and/or the torque of the motor 241. According to an embodiment, the motor 241 may be electrically connected to a processor (e.g., the processor 120 in FIG. 1) located on a circuit board (e.g., the circuit board 204 in FIG. 4) via a flexible printed circuit board.

According to an embodiment, the second housing 202 may accommodate the first circuit board 248 (e.g., a main board). According to an embodiment, a processor, memory, and/or an interface may be mounted on the first circuit board 248. The processor may include, for example, one or more of a central processing unit, an application processor, a graphics processing unit, an image signal processor, a sensor hub processor, or a communication processor. According to various embodiments, the first circuit board 248 may include a flexible printed circuit board-type radio frequency cable (FRC). The first circuit board 248 may be disposed in at least a portion of the second cover member 221 and may be electrically connected to an antenna module and a communication module.

According to an embodiment, the memory may include, for example, volatile memory or nonvolatile memory.

According to an embodiment, the interface may include, for example, a high-definition multimedia interface (HDMI), a universal serial bus (USB) interface, an SD card interface, and/or an audio interface. For example, the interface may electrically or physically connect the electronic device 101 to an external electronic device, and include a USB connector, an SD card/MMC connector, or an audio connector.

According to an embodiment, the electronic device 101 may include a second circuit board 249 (e.g., a sub-circuit board) spaced apart from the first circuit board 248 (e.g., a main circuit board) within the first housing 201. The second circuit board 249 may be electrically connected to the first circuit board 248 via a connection flexible board. The second circuit board 249 may be electrically connected to the battery 289 or electrical components disposed in an end area of the electronic device 101, such as a speaker and/or a SIM socket, to transmit signals and power. According to an embodiment, the second circuit board 249 may accommodate or be connected to a wireless charging antenna (e.g., a coil). For example, the battery 289 may receive power from an external electronic device using the wireless charging antenna. As another example, the battery 289 may transmit power to an external electronic device using the wireless charging antenna.

According to an embodiment, the battery 289 is a device that supplies power to at least one component of the electronic device 101, and may include a non-rechargeable primary battery, a rechargeable secondary battery, or a fuel cell. The battery 289 may be integrally disposed inside the electronic device 101 or may be detachably disposed on the electronic device 101. According to an embodiment, the battery 289 may be configured as a single integrated battery or may include a plurality of separable batteries. According to an embodiment, the battery 289 may be positioned on the frame 213. For example, the battery 289 may be surrounded by the frame 213 and the battery cover 289a. According to another embodiment, the battery may be positioned within the second housing 202 to be slidable with the second housing 202.

According to an embodiment, the guide rail 250 may guide the movement of the multi-bar structure 232. For example, the multi-bar structure 232 may slide along the slit 251 provided in the guide rail 250. According to an embodiment, the guide rail 250 may be connected to the first housing 201. For example, the guide rail 250 may be connected to the first cover member 211 and/or the frame 213. According to an embodiment, the slit 251 may be referred to as a groove or recess provided on the inner surface of the guide rail 250.

According to an embodiment, the guide rail 250 may provide a force to the multi-bar structure 232 based on the driving of the motor 241.

According to an embodiment, when the electronic device 101 is changed from the slid-in state to the slid-out state, the inner portion 252 of the guide rail 250 may provide a force to the multi-bar structure 232. The multi-bar structure 232, which has received the force, may move along the slit 251 of the guide rail 250, and the second housing 202 may slide to be expanded with respect to the first housing 201. At least a portion of the display assembly 230 accommodated between the first cover member 211 and the frame 213 may be expanded to the front surface.

According to an embodiment, when the electronic device 101 is changed from the slid-out state to the slid-in state, the outer portion 253 of the guide rail 250 may provide a force to the bent multi-bar structure 232. The multi-bar structure 232, which has received the force, may move along the slit 251 of the guide rail 250, and the second housing 202 may slide to be at least partially accommodated in the first housing 201. At least a portion of the display assembly 230 may be accommodated between the first cover member 211 and the frame 213.

Referring to FIG. 5A, when the electronic device 101 is in the slid-in state, at least a portion of the second housing 202 may be disposed to be accommodated in the first housing 201. As the second housing 202 is disposed to be accommodated in the first housing 201, the overall volume of the electronic device 101 may be reduced. According to an embodiment, when the second housing 202 is accommodated in the first housing 201, the visually exposed size of the display 231 may be minimized. For example, when the second housing 202 is fully accommodated in the first housing 201, the first display area A1 of the display 231 is visually exposed, and at least a portion of the second display area A2 (e.g., the portion oriented in the -Z axis direction) may be disposed between the battery 289 and the first rear surface plate 215.

Referring to FIG. 5B, when the electronic device 101 is in the slid-out state, at least a portion of the second housing 202 may protrude from the first housing 201. As the second housing 202 protrudes from the first housing 201, the overall volume of the electronic device 101 may increase. According to an embodiment, when the second housing 202 protrudes from the first housing 201, at least a portion of the second display area A2 of the display 231 may be visually exposed to the exterior of the electronic device 101 together with the first display area A1.

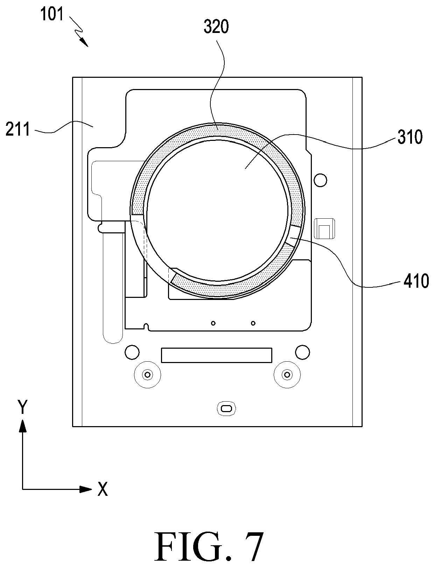

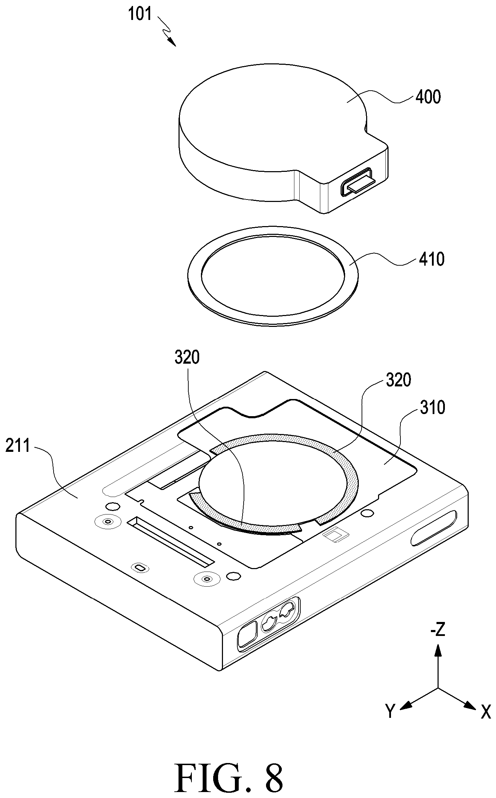

FIG. 7 is a rear view of an electronic device according to an embodiment of the disclosure. FIG. 8 is an exploded perspective view of an accessory and an electronic device including a magnet according to an embodiment of the disclosure.

Referring to FIG. 7 and/or FIG. 8, the electronic device 101 may include a first cover member 211, a power receiving circuit 310, and a magnet 320. The electronic device 101 may be attached to an external accessory 400 using the magnet 320. The configuration of the first cover member 211 of FIG. 7 and/or FIG. 8 may be wholly or partially the same as the configuration of the first cover member 211 of FIG. 4, and the configuration of the power receiving circuit 310 of FIG. 7 may be wholly or partially the same as the configuration of the second circuit board 249 of FIG. 4.

According to an embodiment, the electronic device 101 may receive power from the accessory 400. For example, the electronic device 101 may include a power receiving circuit 310 configured to receive power from the external accessory 400 that includes a power transmitting circuit. The power receiving circuit 310 may include a matching circuit, a rectifying circuit, an adjusting circuit, a switching circuit, and/or a coil. For example, the power receiving circuit 310 may receive wireless power in the form of an electromagnetic wave generated in response to a current and/or voltage applied to a coil of a power transmitting circuit through the coil. For example, the power receiving circuit 310 may receive power by using an electromotive force formed in the coil of the power transmitting circuit and the coil of the power receiving circuit 310.

According to an embodiment, the power receiving circuit 310 and the magnet 320 may be disposed on the housing 201. For example, the power receiving circuit 310 and the magnet 320 may be disposed on the first cover member 211. According to an embodiment, the power receiving circuit 310 and the magnet 320 may be positioned in an opposite direction of the magnetic field detection sensor 350 with respect to the first cover member 211. For example, the power receiving circuit 310 and the magnet 320 may be attached to the outer surface of the first cover member 211. The magnetic field detection sensor 350 may be attached to the inner surface of the first cover member 211.

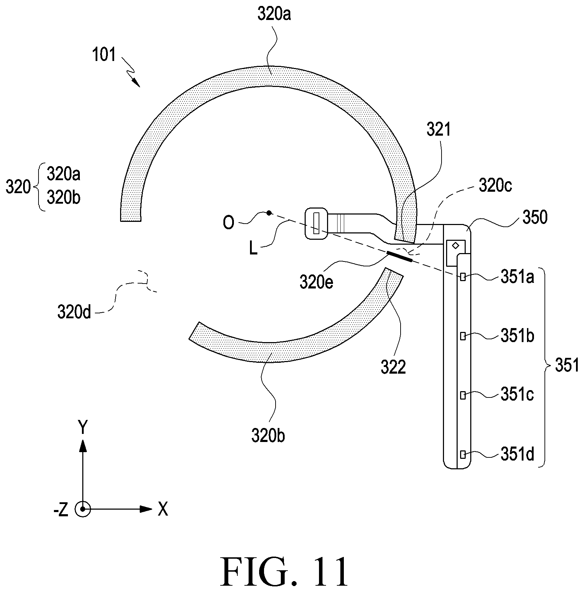

According to an embodiment, the magnet 320 may align or adjust the position of the accessory 400. The magnet 320 may generate a magnetic field to guide the attachment of the accessory 400 (e.g., a wireless power transmitting device). For example, the accessory 400 may be attached to the electronic device 101 based on the magnetic force between the external magnet 410 and the magnet 320. When the accessory 400 is attached to the electronic device 101, the magnet 320 may overlap at least a portion of the external magnet 410 of the accessory 400. According to an embodiment, the external magnet 410 of the accessory 400 and the magnet 320 of the electronic device 101 may be positioned relative to substantially the same center point (e.g., the center point O in FIG. 11).

According to an embodiment, the magnet 320 may be disposed on a housing (e.g., the housing 201 in FIG. 3). For example, the magnet 320 may be disposed on the first cover member 211. The magnet 320 may be positioned between the first cover member 211 and the first rear surface plate (e.g., the rear surface plate 215 in FIG. 4).

According to an embodiment, the accessory 400 may be a wireless charging device or a wireless power transmitting device. For example, the external accessory 400 may include a transmitting coil for wireless power transmission.

According to an embodiment, the accessory 400 may include an external magnet 410. The external magnet 410 may be referred to as an accessory fixing magnet. The accessory 400 may be attached to an electronic device 101 including a magnet 320 using the external magnet 410.

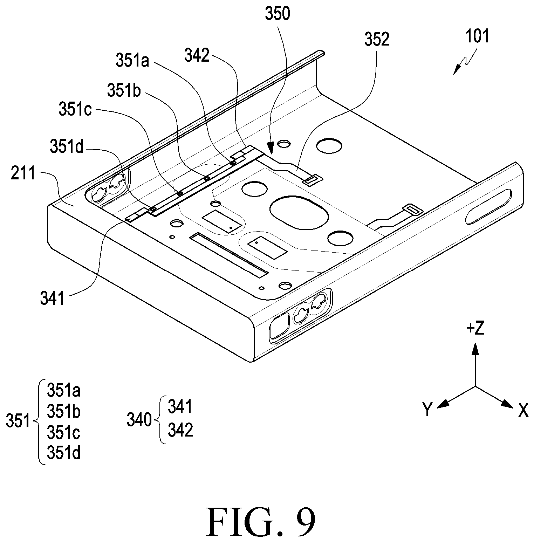

FIG. 9 is a rear perspective view of an electronic device according to an embodiment of the disclosure.

Referring to FIG. 9, the electronic device 101 may include a first cover member 211 and a power receiving circuit 310. The configurations of the first cover member 211 and the power receiving circuit 310 of FIG. 9 may be wholly or partially the same as the configurations of the first cover member 211 and the power receiving circuit 310 of FIG. 7 and/or FIG. 8.

According to an embodiment, the electronic device 101 may determine a slide distance of the electronic device 101. The slide distance may be referred to as the distance that the second housing (e.g., the second housing 202 in FIG. 4) moves relative to the first housing (e.g., the first housing 201 in FIG. 4).

According to an embodiment, the electronic device 101 may include at least one position determination magnet 340 and a magnetic field detection sensor 350 configured to detect the position determination magnet 340.

According to an embodiment, the magnetic field detection sensor 350 may include a plurality of hall sensors 351. The magnetic field detection sensor 350 may detect a magnetic force generated by the position determination magnet 340. A processor (e.g., the processor 120 in FIG. 1) may determine the slide distance of the electronic device 101 based on a signal detected by the magnetic field detection sensor. For example, the processor 120 may determine the distance by which the second housing (e.g., the second housing 202 in FIG. 3) slides relative to the first housing (e.g., the first housing 201 in FIG. 3). The slide distance may be referred to as an extension distance of the electronic device 101.

According to an embodiment, the position determination magnet 340 may include a first position determination magnet 341 and a second position determination magnet 342 spaced apart from the first position determination magnet 341. The magnetic field detection sensor 350 may detect a magnetic field generated from the first position determination magnet 341 in the slid-in state of the electronic device 101 (e.g., FIG. 2). The magnetic field detection sensor 350 may detect a magnetic field generated from the second position determination magnet 342 in the slid-out state of the electronic device 101 (e.g., FIG. 3).

According to an embodiment, the plurality of hall sensors 351 may include a first sensor 351a, a second sensor 351b, a third sensor 351c, and a fourth sensor 351d spaced apart from each other. The first sensor 351a, the second sensor 351b, the third sensor 351c, and the fourth sensor 351d may be arranged along a slide direction of the electronic device 101 (e.g., the Y-axis direction). The processor 120 may determine the slide distance of the electronic device 101 based on the number or type of hall sensors 351 that detect a magnetic field.

According to an embodiment, the number of hall sensors 351 included in the magnetic field detection sensor 350 may be selectively designed. For example, in FIG. 9, the magnetic field detection sensor 350 is illustrated as having a structure including four hall sensors 351, but the number of hall sensors 351 is not limited thereto.

According to an embodiment, the magnetic field detection sensor 350 may include a flexible circuit board 352. The plurality of hall sensors 351 may be arranged on the flexible circuit board 352. The plurality of hall sensors 351 may be electrically connected to the processor (e.g., the processor 120 in FIG. 1) via the flexible circuit board 352.

According to an embodiment, the magnetic field detection sensor 350 and the position determination magnet 340 may be connected to different housings (e.g., the first housing 201 or the second housing 202 in FIG. 3). For example, when the electronic device 101 slides, the magnetic field detection sensor 350 may move relative to the position determination magnet 340. In an embodiment, the position determination magnet 340 may be connected to the first housing 201, and the magnetic field detection sensor 350 may be connected to the second housing 202. In an embodiment, the position determination magnet 340 may be connected to the second housing 202, and the magnetic field detection sensor 350 may be connected to the first housing 201.

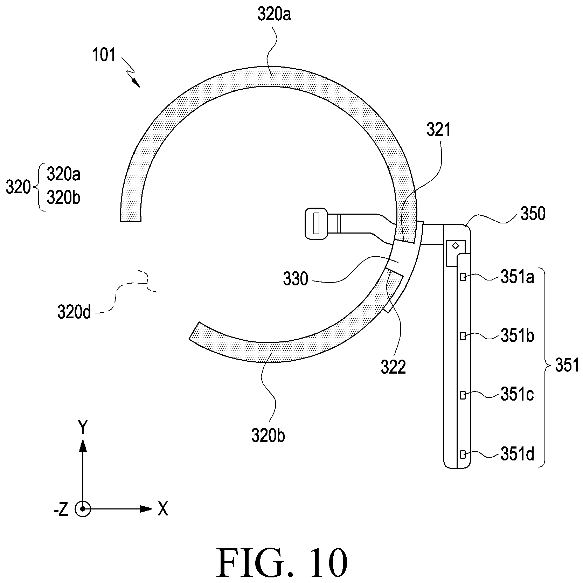

FIG. 10 is a front view of an electronic device including a magnet, a shielding member, and a magnetic field detection sensor according to an embodiment of the disclosure. FIG. 11 is a view illustrating a positional relationship of a magnet according to an embodiment of the disclosure.

Referring to FIG. 10 and/or FIG. 11, an electronic device 101 may include a magnet 320, a shielding member 330, and a magnetic field detection sensor 350. The configurations of the magnet 320, the shielding member 330, and the magnetic field detection sensor 350 of FIG. 10 may be wholly or partially the same as the configurations of the magnet 320, the shielding member 330, and the magnetic field detection sensor 350 of FIG. 9.

According to an embodiment, the magnet 320 may have an arc shape. For example, the magnet 320 may be spaced apart from a center point O by a predetermined distance. According to an embodiment, the magnet 320 may have a "C" shape.

According to an embodiment, the magnet 320 may have a "C" shape or a shape with a portion removed from a ring structure. For example, the magnet 320 may include a first magnet 320a and a second magnet 320b spaced apart from the first magnet 320a. Empty spaces 320c and 320d may be positioned between the first magnet 320a and the second magnet 320b.

According to an embodiment, the empty spaces 320c and 320d between the first magnet 320a and the second magnet 320b may be directed toward an electronic component of the electronic device 101. For example, the empty spaces 320c and 320d may be at least partially positioned between the center point O of the magnet 320 and the electronic component. According to an embodiment, a first empty space 320c may be positioned between the center point O and the magnetic field detection sensor 350. A second empty space 320d may be positioned between the center point O and another electronic component (e.g., the camera module 180 or the antenna module 197). According to an embodiment, a portion of the magnet 320 may be spaced apart from the magnet to form an empty space, thereby reducing the intensity of the magnetic field transmitted to the electronic component. According to an embodiment (not illustrated), the shielding member 330 may be provided in multiple pieces. For example, the shielding member 330 may include a first shielding member positioned within the first empty space 320c and a second shielding member positioned within the second empty space 320d. According to an embodiment, the sizes of the empty spaces 320c and 320d may be selectively designed based on the size or position of the electronic component (e.g., a magnetic field detection sensor 350) affected by a magnetic field generated from the magnet 320.

According to an embodiment, the electronic device 101 may include an electronic component configured to generate a magnetic field or detect a magnetic field. The electronic component may include a magnetic field detection sensor 350, a camera module (e.g., the camera module 180 in FIG. 1), and/or an antenna module (e.g., the antenna module 197 in FIG. 1). The performance of the electronic component may be reduced by a magnetic field generated by the magnet 320 of the electronic device 101 and/or an external magnet (e.g., the external magnet 410 in FIG. 8) of an accessory (e.g., the accessory 400 in FIG. 8) configured to be attached to the electronic device 101. For example, a hall sensor 351 of the magnetic field detection sensor 350, a magnet for optical image stabilization (OIS) function for vibration compensation of the camera module 180, and a sensor for detecting the magnet, a mm Wave antenna module, and/or a UWB patch antenna may have their performance reduced in response to the magnetic field transmitted from the magnet 320 and/or the external magnet 410.

According to an embodiment, the description of the positional relationship between the hall sensor 351 of the magnetic field detection sensor 350 and the shielding member 330 may be applied to the positional relationship between the camera module 180 and the shielding member 330 or the positional relationship between the antenna module 197 and the shielding member 330.

According to an embodiment, the shielding member 330 may reduce the influence of the magnetic field generated from the magnet 320 on the electronic component. For example, the sensor of the electronic component may receive the magnetic field generated from the magnet 320 of the electronic device 101 and/or the external magnet 410 of the accessory 400. The shielding member 330 may absorb at least a portion of the magnetic field generated from the magnet 320 and/or the external magnet 410. Since the shielding member 330 at least partially absorbs of the magnetic field, the intensity of the magnetic field transmitted to the electronic component may be reduced. According to an embodiment, the shielding member 330 may be referred to as a shield or a shielding structure.

According to an embodiment, at least a portion of the shielding member 330 may be positioned on an extension line L between the center point O of the magnet 320 and the electronic component (e.g., the magnetic field detection sensor 350). The extension line L may be a virtual line connecting the center point O of the magnet 320 and a hall sensor 351 of the magnetic field detection sensor 350. Since the shielding member 330 is positioned between the center point O of the magnet 320 and the magnetic field detection sensor 350, the intensity of the magnetic field transmitted to the magnetic field detection sensor 350 (e.g., the magnetic field generated from the magnet 320) may be reduced. According to an embodiment, the extension line L may be a virtual line connecting the center point O of the magnet 320 and a hall sensor (e.g., the first hall sensor 351a) that is closest to the center point O among the plurality of hall sensors 351a, 351b, 351c, and 351d. According to an embodiment, the extension line L may pass through an empty space between the first magnet 320a and the second magnet 320b (e.g., the first void space 320c). According to an embodiment, a cutout center 320e of the magnet 320 may be positioned along the extension line L. The cutout center 320e of the magnet 320 may be referred to as the center position of a portion (e.g., the first empty space 320c) from which the magnet 320 is removed.

According to an embodiment, the magnet 320 may face at least a portion of the shielding member 330. For example, the magnet 320 may include a second end 322 facing the first end 321. According to an embodiment, the first end 321 may be one end of the first magnet 320a, and the second end 322 may be one end of the second magnet 320b. At least a portion of the shielding member 330 may be positioned between the first end 321 and the second end 322. According to an embodiment, the shielding member 330 may be positioned between the magnets 320. For example, the shielding member 330 may be positioned between a portion of the first magnet 320a (e.g., the first end 321) and a portion of the second magnet 320 (e.g., the second end 322).

According to an embodiment, the shielding member 330 may be made of a material for shielding a magnetic field transmitted to the electronic component. For example, the shielding member 330 may include steel plate cold commercial (SPCC). The maximum relative magnetic permeability of the shielding member 330 may be 3,000 to 10,000. The thickness of the shielding member 330 may be 0.2 mm to 5 mm. The saturation flux density of the shielding member 330 may be 1.7 T to 2.3 T. The coercive force of the shielding member 330 may be 380 A/m.

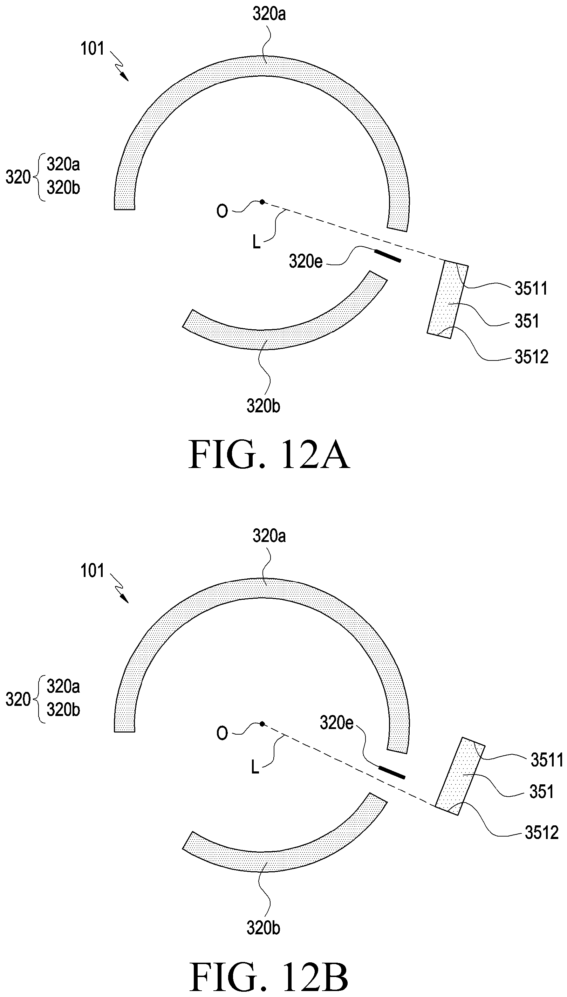

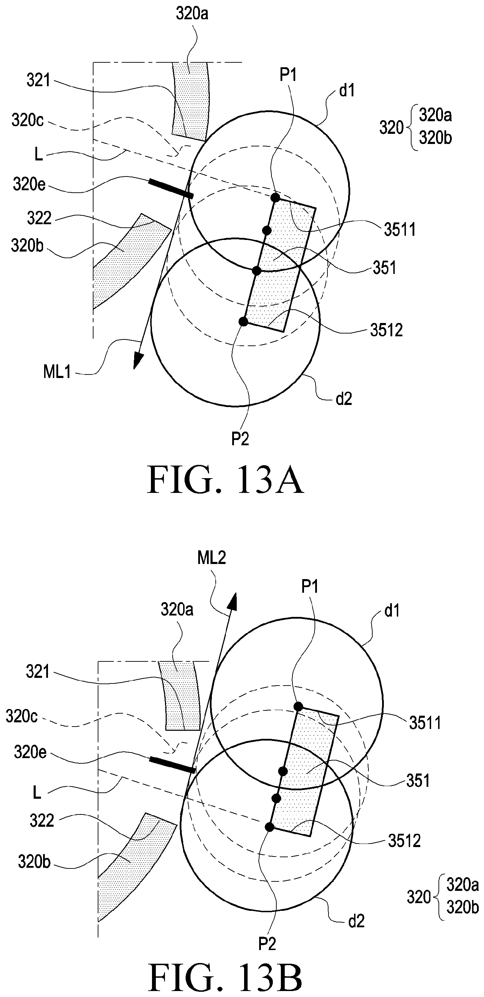

FIGS. 12A and 12B are views illustrating a positional relationship between a magnet and a hall sensor according to an embodiment of the present disclosure. FIGS. 13A and 13B are views illustrating a structure for designing the shape of a magnet according to an embodiment of the disclosure.

Referring to FIG. 12A, FIG. 12B, FIG. 13A, and/or FIG. 13B, the electronic device 101 may include a magnet 320 and a hall sensor 351. The position of the extension line L may be changed based on the positions of the magnet 320 and the hall sensor 351. The configurations of the magnet 320 and the hall sensors 351 of FIG. 12A, FIG. 12A, FIG. 13A, and/or FIG. 13B may be wholly or partially the same as the configurations of the magnet 320 and the hall sensor 351 (e.g., the first hall sensor 351a) of FIG. 10 and/or FIG. 11.

According to an embodiment, the portion from which the magnet 320 is removed may be designed asymmetrically (e.g., FIG. 12A and/or FIG. 12B). The extension line L may be positioned asymmetrically. For example, the distance between the extension line L and the first end 321 of the first magnet 320a may be different from the distance between the extension line L and the second end 322 of the second magnet 320b. According to an embodiment, the position of the extension line L may be selectively designed based on the arrangement relationship between the hall sensor 351 and the center point O.

According to an embodiment (e.g., FIGS. 12A and 13A), the extension line L may be defined based on the first end 3511 of the hall sensor 351. For example, the extension line L may extend from the center point O of the magnet 320 to the first end 3511 of the hall sensor 351. The distance between the extension line L and the first magnet 320a may be smaller than the distance between the center 320e of the first empty space 320c and the first magnet 320a.

According to an embodiment (e.g., FIGS. 12A and 13A), the shape of the magnet 320 may be designed with reference to the first end 3511 of the hall sensor 351. For example, the first empty space 320c of the magnet 320 may be referred to as an area where a portion of the ring-shaped magnet overlapping a first magnet cutout line ML1 is removed. By forming the first empty space 320c, the magnet 320 may have a substantially circular arc shape.

According to an embodiment, the first empty space 320c may be a space where a portion of a magnet positioned on a line extending from the first magnet deletion line ML1 and the center point O of the magnet 320 is removed. The first magnet cutout line ML1 may be an external common tangent of a first virtual circle d1 formed about a first point P1 and a second virtual circle d2 formed about a second point P2. The first point P1 may be a point of an electronic component (e.g., the hall sensor 351) closest to the first end 321. The second point P2 may be a point of an electronic component (e.g., the hall sensor 351) closest to the second end 322. The radius of the first virtual circle d1 may be the distance from the first point P1 to the first end 321 of the magnet 320. The length of the radius of the second virtual circle d2 may be the same as the length of the radius of the first virtual circle d1.

According to an embodiment (e.g., FIGS. 12B and 13B), the extension line L may be defined based on the second end 3512 of the hall sensor 351. For example, the extension line L may extend from the center point O of the magnet 320 to the second end 3512 of the hall sensor 351. The distance between the extension line L and the second magnet 320a may be smaller than the distance between the center 320e of the first empty space 320c and the second magnet 320b.

According to an embodiment (e.g., FIGS. 12B and 13B), the shape of the magnet 320 may be designed with reference to the second end 3512 of the hall sensor 351. For example, the first empty space 320c of the magnet 320 may be referred to as an area where a portion of the ring-shaped magnet overlapping a second magnet cutout line ML2 is removed. By forming the first empty space 320c, the magnet 320 may have a substantially circular arc shape.

According to an embodiment, the first empty space 320c may be a space where a portion of a magnet positioned on a line extending from the second magnet deletion line ML2 and the center point O of the magnet 320 is removed. The second magnet cutout line ML2 may be an external common tangent of a second virtual circle d2 formed about a second point P2 and a first virtual circle d1 formed about a first point P1. The second point P2 may be a point of an electronic component (e.g., the hall sensor 351) closest to the second end 322. The first point P1 may be a point of an electronic component (e.g., the hall sensor 351) closest to the first end 321. The radius of the second virtual circle d2 may be the distance from the second point P2 to the second end 322 of the magnet 320. The length of the radius of the first virtual circle d1 may be the same as the length of the radius of the second virtual circle d2.

The structure of the electronic device 101 of FIG. 12A, FIG. 12B, FIG. 13A, or FIG. 13B (e.g., the arrangement structure of the magnet 320 and the hall sensor 351) may be applied to the previously described embodiments (e.g., the electronic device 101 of FIGS. 1 to 10).

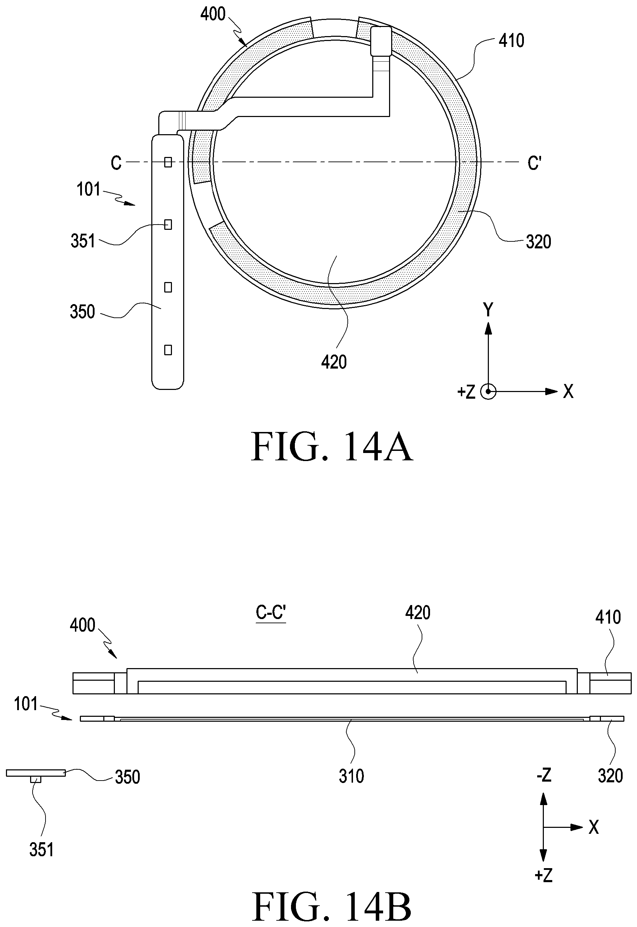

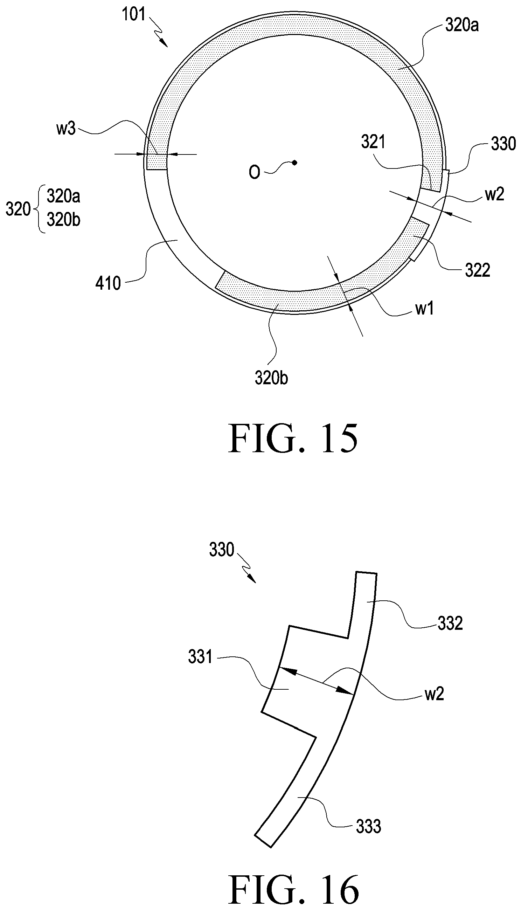

FIG. 14A is a view illustrating the structure of an electronic device facing an external accessory. FIG. 14B is a cross-sectional view taken along line C-C' of FIG. 15.

Referring to FIGS. 14A and 14B, the electronic device 101 may include a power receiving circuit 310, a magnet 320, and a magnetic field detection sensor 350. The magnet 320 may attach an accessory 400 to the electronic device 101. For example, the accessory 400 may include an external magnet 410 and a power transmitting circuit assembly 420 at least partially surrounded by the external magnet 410. The configurations of the power receiving circuit 310, the magnet 320, the accessory 400, and the external magnet 410 of FIGS. 14A and 14B may be wholly or partially the same as the configurations of the power receiving circuit 310, the magnet 320, the accessory 400, and the external magnet 410 of FIG. 8. The configuration of the magnetic field detection sensor 350 of FIGS. 14A and 14B may be wholly or partially the same as the configuration of the magnetic field detection sensor 350 of FIG. 9.

According to an embodiment, the power receiving circuit 310 may include a conductive sheet. The conductive sheet may reduce an eddy current or amplify a signal amplitude. For example, the conductive sheet may reduce magnetic resistance and increase power transmission efficiency. The conductive sheet may include at least one of a nanocrystal sheet or a ferrite. According to an embodiment, at least a portion of the power receiving circuit 310 may be surrounded by a magnet 320.

According to an embodiment, the magnet 320 may generate a magnetic field to attract an external magnet 410 of the accessory 400. By the attractive force between the magnet 320 and the external magnet 410, the accessory 400 may be attached to the electronic device 101. Based on the attractive force between the magnet 320 and the external magnet 410, the power transmitting circuit assembly 420 may be aligned toward the power receiving circuit 310. By making at least a portion of the power transmitting circuit assembly 420 face at least a portion of the power receiving circuit 310, the wireless charging efficiency may be increased.

According to an embodiment, the magnetization characteristic of the magnet 320 may be selectively designed. For example, the arrangement of the N and S poles of the magnet 320 may have a shape to reduce the magnetic field transmitted to the electronic component. According to an embodiment, at least a portion of the magnet 320 may include N and S poles facing in the thickness direction of the electronic device 101 (e.g., the Z-axis direction). At least a portion of the magnet 320 may include the N and S poles oriented in the width direction of the electronic device 101 (e.g., the X-axis direction).

According to an embodiment, the accessory 400 may include an external magnet 410 and a power transmitting circuit assembly 420 at least partially surrounded by the external magnet 410. The power transmitting circuit assembly 420 may include a transmitting coil and a ferrite at least partially surrounded by the transmitting coil. The ferrite may reduce magnetic resistance and increase power transmitting efficiency.

According to an embodiment, when the accessory 400 is attached to the electronic device 101, at least a portion of the magnetic field generated from the magnet 320 and at least a portion of the magnetic field generated from the external magnet 410 may be transmitted to the magnetic field detection sensor 350.

FIG. 15 is a front view of an electronic device including a magnet and a shielding member with an external magnet attached thereto according to an embodiment of the disclosure. FIG. 16 is a view of a shielding member according to an embodiment of the disclosure.

Referring to FIGS. 15 and 16 , the electronic device 101 may include a magnet 320 and a shielding member 330. The configurations of the magnet 320, the shielding member 330, and the external magnet 410 of FIG. 15 and/or FIG. 16 may be wholly or partially the same as the configurations of the magnet 320, the shielding member 330, and the external magnet 410 of FIG. 14B.

According to an embodiment, the shielding member 330 may absorb at least a portion of the magnetic field generated from the magnet 320 and the external magnet 410. For example, the shielding member 330 may reduce the intensity of the magnetic field transmitted to the electronic component (e.g., the hall sensor 351 of the magnetic field detection sensor 350 in FIG. 14B).

According to an embodiment, the shielding member 330 may have a shape to reduce the transmission of the magnetic field generated from the magnet 320 and the magnetic field generated from the external magnet 410 to the electronic component. For example, the shielding member 330 may include a central area 331 and wing structures 332 and 333 protruding from the central area 331. The central area 331 may face the magnet 320. For example, the central area 331 may be positioned between the first end 321 of the first magnet 320a and the second end 322 of the second magnet 320b. At least a portion of the central area 331 may be positioned between the first wing structure 332 and the second wing structure 333. The wing structure 332 may face the external magnet 410. For example, the wing structure 332 may have a structure extending along the outer edge of the magnet 320. According to an embodiment, the wing structures 332 and 333 may include a first wing structure 332 formed along the edge of the first magnet 320a and the second wing structure 333 formed along the edge of the second magnet 320b. For example, the first wing structure 332 may have an arc shape extending along a portion of the first magnet 320a. The second wing structure 333 may have an arc shape extending along a portion of the second magnet 320b. The central area 331 of the shielding member 330 may face at least a portion of the external magnet 410. The wing structures 332 and 333 of the shielding member 330 may at least partially not face the external magnet 410. For example, the wing structures 332 and 333 may at least partially protrude in the width direction of the electronic device 101 more than the external magnet 410.

According to an embodiment, the shape of the shielding member 330 may be selectively designed based on the position of the electronic component, the sensitivity of the electronic component, and the separation distance between the magnet 320 and the electronic component. For example, at least one of the first wing structure 332 or the second wing structure 333 may be selectively removed. In an embodiment, the length of the first wing structure 332 may be different from that of the second wing structure 333.

According to an embodiment, the size of the external magnet 410 may be larger than that of the magnet 320. For example, the external magnet 410 may have a ring or arc shape formed about the same point as the center point O of the magnet 320. The external magnet 410 may have a third width w3 greater than the first width w1 of the magnet 320. According to an embodiment, the inner diameter of the external magnet 410 may be substantially the same as the inner diameter of the magnet 320, and the outer diameter of the external magnet 410 may be greater than the outer diameter of the magnet 320.

According to an embodiment, the shielding member 330 may have a width greater than the magnet 320 and/or the external magnet 410. For example, the second width w2 of the central area 331 of the shielding member 330 may be greater than the third width w3 of the magnet 320 or the first width w1 of the external magnet 410. By making the second width w2 of the shielding member 330 greater than the first width w1 of the magnet 320 and the third width w3 of the external magnet 410, the transmission of the magnetic field generated by the magnet 320 as well as the magnetic field generated by the external magnet 410 to the electronic components may be reduced. According to an embodiment, the second width w2 may be selectively designed based on the sensitivity of the electronic component and the separation distance between the magnet 320 and the electronic component.

The structure of the shielding member 330 of FIG. 15 and/or FIG. 16 may be applied to the previously described embodiments (e.g., the electronic device 101 of FIGS. 1 to 14B). For example, the electronic device 101 may include the shielding member 330 described with reference to FIG. 15 and/or FIG. 16. However, the shape of the shielding member 330 is not limited thereto. For example, depending on the internal design of the electronic device 101, at least one of the first wing structure 332 or the second wing structure 333 may be omitted.

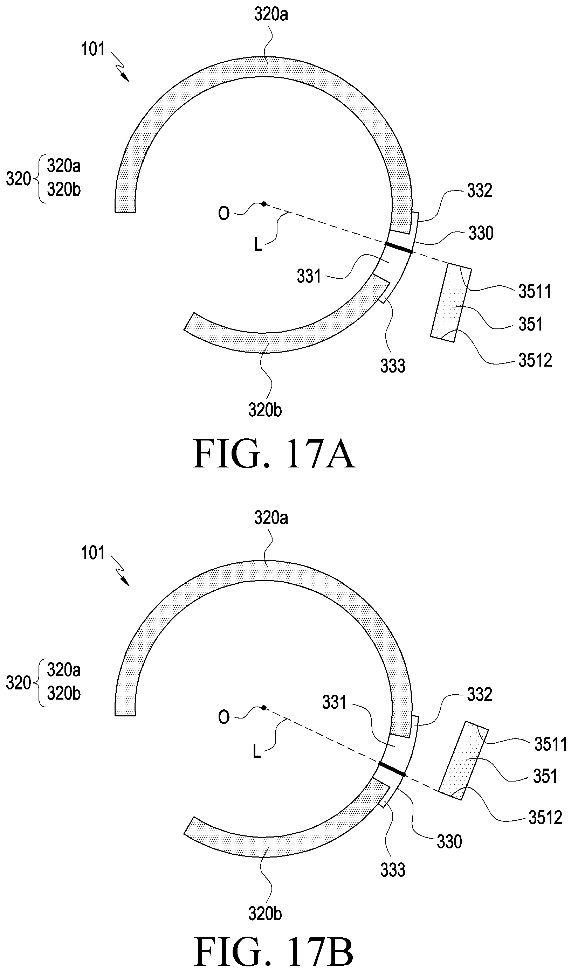

FIGS. 17A and 17B are views illustrating a positional relationship between the shielding member and the hall sensor according to an embodiment of the disclosure.

Referring to FIGS. 17A and 17B, the electronic device 101 may include a magnet 320 and a hall sensor 351. The position of the extension line L may be changed based on the positions of the magnet 320 and the hall sensor 351.

The configurations of the magnet 320 and the hall sensor 351 of FIGS. 17A and 17B may be wholly or partially the same as the configurations of the magnet 320 and the hall sensor 351 (e.g., the first hall sensor 351a) of FIG. 12A, FIG. 12B, FIG, 13A, and/or FIG. 13B, and the configuration of the shielding member 330 of FIGS. 17A and 17B may be wholly or partially the same as the configuration of the shielding member 330 of FIGS. 15 and 16. For example, the description of the magnet 320 including the first magnet 320a and the second magnet 320b of FIG. 12A, FIG. 12B, FIG. 13A, and/or FIG. 13B, and the hall sensor 351 including the first end 3511 and the second end 3512 may be applied to FIGS. 17A and 17B.

According to an embodiment, the shielding member 330 may be positioned between the center point O of the magnet 320 and the electronic component (e.g., the hall sensor 3511). For example, the shielding member 330 may be positioned on the extension line L connecting the center point O of the magnet 320 and the electronic component. At least a portion of the central area 331 of the shielding member 330 may be positioned on the extension line L.

According to an embodiment, the shape of the shielding member 330 may be designed asymmetrically. For example, the distance between the extension line L and the first wing structure 332 may be different from the distance between the extension line L and the second wing structure 333. According to an embodiment (e.g., FIG. 17A), the extension line L may extend from the center point O of the magnet 320 to the first end 3511 of the hall sensor 351. The first wing structure 332 of the shielding member 330 may be disposed closer to the extension line L than the second wing structure 333. According to an embodiment (e.g., FIG. 17B), the extension line L may extend from the center point O of the magnet 320 to the second end 3512 of the hall sensor 351. The second wing structure 333 of the shielding member 330 may be disposed closer to the extension line L than the first wing structure 332. The position where the shielding member 330 is disposed may be selectively designed based on the intensity of the magnetic field of the magnet 320 and/or the position of the electronic component (e.g., the hall sensor 351).

The structure of the electronic device 101 of FIG. 17A and/or FIG. 17B (e.g., the arrangement structure of the magnet 320, the shielding member 330, and the hall sensor 351) may be applied to the previously described embodiments (e.g., the electronic device 101 of FIGS. 1 to 16).

An electronic device (e.g., a portable terminal) may include a display having a flat surface or a flat surface and a curved surface. An electronic device including a display may have a limitation in implementing a screen larger than the size of the electronic device due to a fixed display structure. Accordingly, electronic devices including a rollable display are being researched.

An electronic device may include an accessory attachable to the electronic device or a magnet attachable to a wireless power transmitting device in order to maximize portability and convenience for a user. The accessory or the wireless power transmitting device may include an external magnet to be attached to the electronic device. The performance of an electronic component of the electronic device may be reduced by magnetic fields generated by a magnet inside the electronic device and an external magnet.

An embodiment of the disclosure may provide an electronic device that includes a shielding member capable of reducing the intensity of a magnetic field generated by a magnet positioned inside an external accessory or a wireless power transmitting device transmitted to the electronic component. By reducing the intensity of the magnetic field transmitted to the electronic component, malfunction of the electronic component may be reduced and the sensing accuracy of the electronic component may be increased. For example, the accuracy of a hall sensor for determining a slide distance in a rollable electronic device may be increased.

According to an embodiment of the disclosure, an electronic device (e.g., the electronic device 101 in FIG. 2) may include a housing (e.g., the housing 210 in FIG. 3) including a first housing (e.g., the first housing 201 in FIG. 3) and a second housing (e.g., the second housing 202 in FIG. 3) configured to move relative to the first housing, a display (e.g., the display 203 in FIG. 3) configured to be unrolled based on the sliding of the second housing, an electronic component (e.g., the magnetic field detection sensor 350 in FIG. 9, the camera module 249b in FIG. 3, and/or the antenna module 197 in FIG. 1) disposed within the housing and configured to detect a magnetic field, a magnet (e.g., the magnet 320 in FIG. 7) disposed within the housing, including a first end (e.g., the first end 321 in FIG. 10) and a second end (e.g., the second end 322 in FIG. 10) facing the first end, and having an arc shape, and a shielding member (e.g., the shielding member 330 in FIG. 10) having at least a portion positioned between the first end and the second end, and at least a portion positioned on an extension line (e.g., the extension line L in FIG. 9) between the center point of the magnet (e.g., the center point O in FIG. 9) and the electronic component. Due to the shielding member, the intensity of the magnetic field transmitted to the electronic component may be reduced, thereby reducing malfunction of the electronic component. For example, the shielding member may reduce the intensity of the magnetic field generated by the magnet and/or the magnetic field included in an external accessory to be attached to the electronic device transmitted to the electronic component.

According to an embodiment of the disclosure, the electronic device may reduce the intensity of at least some of the magnetic field generated by the magnet and/or at least some of the magnetic field generated by the external magnet and transmitted to the electronic component (e.g., a magnetic field detection sensor, a camera module, and/or an antenna module) by using the shielding member positioned on the extension line connecting the center point of the magnet and the electronic component. In addition, various effects that are directly or indirectly identified through this document may be provided.

According to an embodiment, the electronic device may further include a position determination magnet (e.g., the position determination magnet 340 in FIG. 9) disposed within the housing. The electronic component may include a magnetic field detection sensor (e.g., the magnetic field detection sensor 350 in FIG. 9) configured to slide relative to the position determination magnet, and to detect a magnetic field generated from the position determination magnet.

According to an embodiment, the electronic device may further include a processor (e.g., the processor 120 in FIG. 1) configured to determine a slide distance of the electronic device based on a signal detected by the magnetic field detection sensor.

According to an embodiment, the magnetic field detection sensor may include a plurality of hall sensors (e.g., the hall sensors 351 in FIG. 10) arranged along a first direction in which the electronic device slides (e.g., the Y-axis direction of FIG. 10). The extension line in the electronic device is a line extending from the center point of the magnet to a first hall sensor (e.g., the first hall sensor 351 in FIG. 9) closest to the magnet among the plurality of hall sensors.

According to an embodiment, the shielding member has relative magnetic permeability of 3,000 to 10,000, and saturation magnetic flux density of 1.7 T to 2.3 T. The magnetic field transmitted to the electronic component may be at least partially shielded by the shielding member.

According to an embodiment, the first magnet may include a first magnet (e.g., the first magnet 320a in FIG. 10) including the first end and a second magnet (e.g., the second magnet 320b in FIG. 10) spaced apart from the first magnet and including the second end.

According to an embodiment, the shielding member may include a central area (e.g., the central area 330 in FIG. 16) positioned between the first magnet and the second magnet, a first wing structure (e.g., the first wing structure 332 in FIG. 16) extending from the central area along an edge of the first magnet, and a second wing structure (e.g., the second wing structure 333 in FIG. 16) extending from the central area along an edge of the second magnet.

According to an embodiment, the electronic device may further include a power receiving circuit (e.g., the power receiving circuit 310 in FIG. 7) disposed within the housing and having at least a portion facing the magnet.

According to an embodiment, the first housing may include a first cover member (e.g., the first cover member 211 in FIG. 4) and a frame (e.g., the frame 213 in FIG. 4) surrounded by the first cover member. The second housing may include a second cover member (e.g., the second cover member 221 in FIG. 4) at least partially accommodated within the first cover member. The magnet and the power receiving circuit may be disposed on the first cover member.

According to an embodiment, the magnet may have a first width (e.g., the first width w1 in FIG. 14B) smaller than a second width (e.g., the second width w2 in FIG. 14B) of the shielding member. Since the width of the shielding member is larger than the width of the magnet, the magnetic field generated from the magnet and the external magnet attached to the magnet may be effectively shielded by the shielding member.

According to an embodiment, the electronic component may include a camera module (e.g., the first camera module 180 in FIG. 1 and/or the camera modules 249a and 249b in FIG. 3) disposed on the housing. The shielding member may be positioned between the center point of the magnet and the camera module. By shielding the magnetic field transmitted to the camera module by the shielding member, the camera performance (e.g., anti-shake function) may be improved.

According to an embodiment, the electronic component may further include an antenna module (e.g., antenna module 197 in FIG. 1) disposed within the housing. The shielding member may be positioned between the center point of the magnet and the antenna module. By shielding the magnetic field transmitted to the antenna module by the shielding member, the antenna performance may be improved.

According to an embodiment, the electronic component may further include a driving structure (e.g., the driving structure 240 in FIG. 4) configured to slide the second housing to slide relative to the first housing. The driving structure may include a motor (e.g., the motor 241 in FIG. 6) disposed within the first housing and configured to generate a driving force for moving the second housing relative to the first housing, and a gear (e.g., the gear 244 in FIG. 6) connected to the motor and a rack (e.g., the rack 242 in FIG. 6) connected to the second housing and configured to mesh with the gear.

According to an embodiment, the electronic device may further include a multi-bar structure (e.g., the multi-bar structure 232 of FIG. 4) supporting at least a portion of the display, and a guide rail (e.g., the guide rail 250 in FIG. 4) including a slit (e.g., the slit 251 in FIG. 4) and configured to guide the movement of the multi-bar structure, and connected to the frame.

According to an embodiment, the display may include a first display area (e.g., the first display area A1 in FIG. 4) connected to the second housing, and a second display area (e.g., the second display area A2 in FIG. 4) extending from the first display area and configured to be rolled or unrolled based on the sliding of the second housing.

According to an embodiment of the disclosure, an electronic device (e.g., the electronic device 101 in FIG. 3) may include a housing (e.g., the housing 210 in FIG. 3) including a first housing (e.g., the first housing 201 in FIG. 3) and a second housing (e.g., the second housing 202 in FIG. 3) configured to move relative to the first housing, a display (e.g., the display 203 in FIG. 3) configured to be unrolled based on the sliding of the second housing, a position determination magnet (e.g., the magnet 340 in FIG. 9) disposed within in the housing, a magnetic field detection sensor (e.g., the magnetic field detection sensor 350 in FIG. 9) configured to slide relative to the position determination magnet, and including a hall sensor (e.g., the hall sensor 351 in FIG. 9) configured to detect a magnetic field generated from the position determination magnet, a magnet (e.g., the magnet 321 in FIG. 10) disposed within the housing and including a first end (e.g., the first end 321 in FIG. 10) and a second end (e.g., the second end 322 in FIG. 10) facing the first end, and a shielding member (e.g., the shielding member 330 in FIG. 10) at least partially positioned between the first end and the second end, and positioned on an extension line (e.g., the extension line L in FIG. 11) between the center point of the magnet (e.g., the center point O in FIG. 11) and the hall sensor.

According to an embodiment, the first magnet may include a first magnet (e.g., the first magnet 320a in FIG. 11) including the first end and a second magnet (e.g., the second magnet 320b in FIG. 11) spaced apart from the first magnet and including the second end.

According to an embodiment, the shielding member may include a central area (e.g., the central area 331 in FIG. 15) positioned between the first magnet and the second magnet, a first wing structure (e.g., the first wing structure 332 in FIG. 15) extending from the central area along an edge of the first magnet, and a second wing structure (e.g., the second wing structure 333 in FIG. 15) extending from the central area along an edge of the second magnet.

According to an embodiment, the shielding member has relative magnetic permeability of 3,000 to 10,000, and saturation magnetic flux density of 1.7 T to 2.3 T.

According to an embodiment, the electronic device may further include a power receiving circuit (e.g., the power receiving circuit 310 in FIG. 7) disposed within the housing and having at least a portion facing the magnet.

It may be apparent to a person ordinarily skilled in the art to which the disclosure belongs that the above-described electronic device including a shielding member according to the disclosure is not limited by the above-described embodiments and drawings, and may be variously substituted, modified, and changed within the technical scope of the disclosure.

## Claims

1. An electronic device (101) comprising:
a housing (210) comprising a first housing (201) and a second housing (202) configured to move relative to the first housing;
a display (203) configured to be unrolled based on sliding of the second housing;
an electronic component (180, 197, 249a, 249b, 350) disposed within the housing and configured to detect a magnetic field;
a magnet (320) disposed within the housing, comprising a first end (321) and a second end (322) facing the first end, and having an arc shape; and
a shielding member (330) comprising at least a portion positioned between the first end and the second end, and at least a portion positioned on an extension line (L) between a center point (O) of the magnet and the electronic component.

2. The electronic device of claim 1, further comprising:
a position determination magnet (340) disposed within the housing,
wherein the electronic component comprises a magnetic field detection sensor (350) configured to slide relative to the position determination magnet, and to detect a magnetic field generated from the position determination magnet.

3. The electronic device of claim 1 or 2, further comprising:
a processor (120) configured to determine a slide distance of the electronic device based on a signal detected by the magnetic field detection sensor.

4. The electronic device of any one of the preceding claims, wherein the magnetic field detection sensor comprises a plurality of hall sensors (351) arranged along a first direction in which the electronic device slides, and
wherein the extension line is a line extending from the center point of the magnet to a first hall sensor (351a) closest to the magnet among the plurality of hall sensors.

5. The electronic device of any one of the preceding claims, wherein the shielding member has relative permeability of 3,000 to 10,000, and saturation magnetic flux density of 1.7 T to 2.3 T.

6. The electronic device of any one of the preceding claims, wherein the magnet comprises a first magnet (320a) comprising the first end and a second magnet (320b) spaced apart from the first magnet and comprising the second end.

7. The electronic device of any one of the preceding claims, wherein the shielding member comprises:
a central area (331) positioned between the first magnet and the second magnet;
a first wing structure (332) extending from the central area along an edge of the first magnet; and
a second wing structure (333) extending from the central area along an edge of the second magnet.

8. The electronic device of any one of the preceding claims, further comprising:
a power receiving circuit (310) disposed within the housing and comprising at least a portion facing the magnet.

9. The electronic device of any one of the preceding claims, wherein the first housing comprises a first cover member (211) and a frame (213) surrounded by the first cover member,
wherein the second housing comprises a second cover member (221) at least partially accommodated within the first cover member, and
wherein the magnet and the power receiving circuit are disposed on the first cover member.

10. The electronic device of any one of the preceding claims, wherein a first width (w1) of the magnet is smaller than a second width (w2) of the shielding member.

11. The electronic device of any one of the preceding claims, wherein the electronic component comprises a camera module (180, 249a, 249b) disposed on the housing, and
wherein the shielding member is positioned between the center point of the magnet and the camera module.

12. The electronic device of any one of the preceding claims, wherein the electronic component further comprises an antenna module (197) disposed within the housing, and
wherein the shielding member is positioned between the center point of the magnet and the antenna module.

13. The electronic device of any one of the preceding claims, further comprising:
a driving structure (240) configured to slide the second housing relative to the first housing,
wherein the driving structure comprises:
a motor (241) disposed within the first housing and configured to generate a driving force for moving the second housing relative to the first housing;
a gear (244) connected to the motor; and
a rack (242) connected to the second housing and configured to be engaged with the gear.

14. The electronic device of any one of the preceding claims, further comprising:
a multi-bar structure (232) configured to support at least a portion of the display; and
a guide rail (250) connected to the first housing and comprising a slit (251) configured to guide movement of the multi-bar structure.

15. The electronic device of any one of the preceding claims, wherein the display comprises a first display area (A1) connected to the second housing and a second display area (A2) extending from the first display area and configured to be rolled or unrolled based on the sliding of the second housing.
